# EUROPEAN PATENT SPECIFICATION

(11) **EP 1 840 102 B1**
(45) Date of publication and mention of the grant of the patent: **22.05.2013**
(21) Application number: 07251227.0
(22) Date of filing: 22.03.2007
(51) Int. Cl.: C04B 35/195, C04B 35/622

(54) **Process for the production of a ceramic green sheet**
Verfahren zur Herstellung einer keramischen Grünfolie
Un procédé pour fabriquer une feuille en céramique verte

(30) Priority: 28.03.2006 JP 2006087530
(43) Date of publication of application: 03.10.2007
(73) Proprietor: NGK Insulators, Ltd., Nagoya-City, Aichi Pref. 467-8530 (JP)
(72) Inventor: Fujioka, Yasumasa, c/o NGK Insulators, Ltd., Mizuho-ku, Nagoya City, Aichi-ken 467-8530 (JP); Suzuki, Junichi, c/o NGK Insulators, Ltd., Mizuho-ku, Nagoya City, Aichi-ken 467-8530 (JP); Kondou, Atsuo, c/o NGK Insulators, Ltd., Mizuho-ku, Nagoya City, Aichi-ken 467-8530 (JP); Masuda, Masaaki, c/o NGK Insulators, Ltd., Mizuho-ku, Nagoya City, Aichi-ken 467-8530 (JP)
(74) Representative: Paget, Hugh Charles Edward

(56) References cited:
- EP-A- 1 582 509
- EP-A1- 0 602 252
- EP-A2- 0 132 740
- US-B1- 6 395 117

## Description

### Background of the Invention and Related Art Statement

The present invention relates to a process for production of a ceramic green sheet and. More particularly, the present invention relates to production of a ceramic green sheet which, when fired, can be made into a tape-shaped ceramic formed body which is dense and superior in thermal shock resistance.

Tape-shaped ceramic formed bodies have been conventionally used in thin ceramic products such as a wiring board and the like. As the material for such a tape-shaped ceramic formed body, there have been used alumina, zirconia, aluminum nitride, silicon nitride, etc. Of these materials, alumina is superior in strength and heat conductivity and accordingly is in wide use a wiring board.

These tape-shaped ceramic formed bodies can be obtained by mixing a ceramic raw material, an organic material (e.g. a binder), etc. to obtain a slurry, forming the slurry into a tape-shaped green sheet by, for example, a doctor blade method, and firing the tape-shaped green sheet (see, for example, Patent Literatures 1 to 3).
Patent Literature 1: JP-A-2001-106579
Patent Literature 2: JP-A-10-182239
Patent Literature 3: JP-A-4-12062

The ceramic formed bodies obtained by firing a tape-shaped ceramic green sheet according to the above-mentioned conventional process, are made of the above material and consequently have had a problem in that they are low in thermal shock resistance and unusable in environments subjected to thermal shock.

Therefore, the above material has been unusable in, for example, the electrode for purification of exhaust gas emitted from factory, the electrode for purification of exhaust gas emitted from vehicle (e.g. automobile) and the terminal for sensing of exhaust gas component, or the like, because the material is unable to withstand sharp thermal shock. Of the above-mentioned ceramic materials, silicon nitride is superior in thermal shock resistance but has had problems that it is expensive and moreover is susceptible to oxidation when used under high temperature environment.

Cordierite is a ceramic which is inexpensive and superior in thermal shock resistance; however, there has been known no method of using cordierite in a tape form. Further, when cordierite is used in applications wherein electricity is used, such as a wiring board and the like, there has been a problem that it is difficult to make cordierite dense and its dielectric breakdown tends to occur. JP-A-2005-314215 discloses a dense cordierite sintered body but makes no disclosure on the method of forming it into a sheet shape.

### Summary of the Invention

The present invention has been made in view of the above-mentioned problems. The present invention aims at providing a process of producing a ceramic green sheet which, when fired, can be made into a tape-shaped ceramic formed body which is dense and superior in thermal shock resistance.

In order to achieve the above aim, the present invention provides a process for producing a ceramic green sheet as set out in claim 1.
Preferably the slurry further contains 0.5 to 2.5 parts by mass of a dispersing agent and 5.0 to 9.0 parts by mass of a plasticizer relative to 100 parts by mass of the cordierite powder.

Thus, the ceramic green sheet produced by the present invention contains 100 parts by mass of a cordierite powder having an average particle diameter of 1.0 to 5.0 µm and a BET specific surface area of 4.0 to 10.0 m²/g and 14.0 to 19.0 parts by mass of a binder; therefore, it can form, by firing, a tape-shaped ceramic formed body which is dense and superior in thermal shock resistance.

### Description of the Preferred Embodiments

Embodiments of the present invention are described in detail below. However, the present invention is in no way restricted to the following embodiments.

The ceramic green sheet produced according to the present invention contains 100 parts by mass of a cordierite powder having an average particle diameter of 1.0 to 5.0 µm and a BET specific surface area of 4.0 to 10.0 m²/g and 14.0 to 19.0 parts by mass of a binder.

The ceramic green sheet is obtained by using cordierite as a raw material and subjecting it to forming. Therefore, the sheet, when fired, is superior in thermal shock resistance.

The cordierite powder used has an average particle diameter of 1.0 to 5.0 µm and a BET specific surface area of 4.0 to 10.0 m²/g. Therefore, the ceramic green sheet, when fired, is unlikely to have defects, etc. and can be made dense.

The average particle diameter of the cordierite powder is 1.0 to 5.0 µm, preferably 1.0 to 4.0 µm, particularly preferably 2.0 to 3.0 µm. An average particle diameter of less than 1.0 µm is not preferred because too much time is required for obtaining such a fine powder and, in forming, an enormous amount of a binder is needed, which yields a binder distribution in the formed body and gives effect on the fired body. An average particle diameter of more than 5.0 µm is not preferred, either, because when the ceramic green sheet has been fired, the fired body is not dense. Incidentally, the average particle diameter is a value obtained by measurement according to a laser diffraction method with the refractive index of cordierite being taken as 1.55.

The BET specific surface area of the cordierite powder is 4.0 to 10.0 m²/g, preferably 5.0 to 8.0 m²/g, more preferably 6.0 to 7.0 m²/g. Since the BET specific surface area is in such a range, the cordierite powder is unlikely to cause agglomeration when formed into a sheet shape and, when the sheet is fired, the fired body is unlikely to have defects, etc. and can be made dense. A BET specific surface area of less than 4.0 m²/g is not preferred because a dense fired body is difficult to obtain. A BET specific surface area of more than 10.0 m²/g is not preferred, either, because the cordierite powder tends to cause agglomeration and, when fired, is easy to generate defects, etc. The BET specific surface area can be measured as follows. First, a cordierite powder sample is placed in an adsorption cell; the cell inside is made vacuum while heating, to remove the gas molecules adsorbed on the sample surface; and the mass of sample is measured. The adsorption cell is again fitted to the apparatus and nitrogen is allowed to flow into the cell. Thereby, nitrogen is adsorbed on the sample surface. By increasing the flow amount of nitrogen, nitrogen gas molecules form a plurality of layers on the sample surface. In this process, the change in adsorption amount relative to change in pressure is plotted. From the resulting graph is determined the amount of gas molecules adsorbed on the sample surface alone, using the BET adsorption isotherm. Since the area occupied by adsorbed nitrogen molecules is known beforehand, the surface area of sample can be measured from the adsorbed gas amount.

The ceramic green sheet produced by the present invention contains 100 parts by mass of a cordierite powder and 14.0 to 19.0 parts by mass of a binder. The content of the binder is preferably 15.0 to 18.0 parts by mass, more preferably 16.0 to 17.0 parts by mass. Such a binder amount is preferred because the sheet shape obtained by forming is maintained thereby and the generation of defects, etc. when fired can be prevented. A binder content of less than 14.0 parts by mass relative to 100 parts by mass of the cordierite powder is not preferred because, with such a content, forming into a sheet shape is difficult and, when the sheet is fired, defects, etc. are generated. A binder content of more than 19.0 parts by mass is not preferred because, with such a content, drying in forming is difficult and, even if drying is possible, the dried sheet is sticky, making very difficult the handling in subsequent operation.

As to the kind of the binder, there is no particular restriction and any of a water-based binder and a non-aqueous binder may be used. As the water-based binder, there can be preferably used methyl cellulose, polyvinyl alcohol, polyethylene oxide, etc. As the non-aqueous binder, there can be preferably used polyvinyl butyral, acrylic resin, polyethylene, polypropylene, etc. As the acrylic resin, there can be mentioned (meth)acrylic resin, (meth)acrylic acid ester copolymer, acrylic acid ester-methacrylic acid ester copolymer, etc.

As to the cordierite powder contained in the ceramic green sheet of the present invention, the cordierite content is preferably 93 mass % or more, more preferably 95 mass % or more, particularly preferably 99 mass % or more, most preferably 100 mass %. Thus, a higher cordierite content in the cordierite powder can produce a sheet-shaped, fired body having an excellent thermal shock resistance. In the cordierite powder, there may be contained, as components other than cordierite, mullite, spinel, sapphirine, corundum, etc., which are composed of the A1, Mg, Si and O, contained in cordierite.

The ceramic green sheet of the present invention may contain, besides a ceramic and a binder, a plasticizer, a dispersing agent, etc.

The plasticizer is contained in an amount of preferably 5.0 to 9.0 parts by mass, more preferably 6.0 to 8.0 parts by mass relative to 100 parts by mass of the cordierite powder. With a plasticizer amount of less than 5.0 parts by mass, the ceramic green sheet is too soft and tends to deform in processing. With a plasticizer amount of more than 9.0 parts by mass, the ceramic green sheet tends to be too hard and is inferior in handleability (for example, crack is occurred just by bending) .

As the plasticizer, there can be used glycerine, polyethylene glycol, dibutyl phthalate, di-2-ethylhexyl phthalate, diisononyl phthalate, etc.

The dispersing agent is contained in an amount of preferably 0.5 to 2.5 parts by mass, more preferably 1.0 to 2.0 parts by mass relative to 100 parts by mass of the cordierite powder. When the dispersing agent is contained in an amount of less than 0.5 parts by mass, the dispersibility of the cordierite powder is low and the ceramic green sheet obtained may have defects, etc.; when the dispersing agent is contained in an amount of more than 2.5 parts by mass, the dispersibility of the cordierite powder is unchanged but the amount of impurities during firing is larger.

Alternatively, with respect to the dispersing agent, there can be used, as water-based dispersing agents, an anionic surfactant, a wax emulsion, pyridine, etc. and, as non-aqueous dispersing agents, a fatty acid, a phosphoric acid ester, a synthetic surfactant, etc.

In the term "ceramic green sheet", the thickness thereof is ordinarily about 50 µm to 2.0 mm. With respect to the thickness of the ceramic green sheet of the present invention, there is no particular restriction, and the thickness can be appropriately selected depending upon the application of the sheet. When a present ceramic green sheet of 0.05 to 0.2 mm in thickness is fired, the fired body is suited for use as a wiring board; and when a present ceramic green sheet of 0.2 to 0.5 mm in thickness is fired, the fired body is suited for use as an electrode for purification of exhaust gas.

Next, description is made on the process for production of the ceramic green sheet of the present invention.

### (Slurry preparation step)

In the process for production of the present ceramic green sheet, first, there is prepared a slurry containing 100 parts by mass of a cordierite powder having an average particle diameter of 1.0 to 5.0 µm and a BET specific surface area of 4.0 to 10.0 m²/g and 14.0 to 19.0 parts by mass of a binder (a slurry preparation step).

The cordierite powder is prepared, for example, as follows. First, a cordierite-forming material is fired to form cordierite. Here, the cordierite-forming material means a raw material which becomes cordierite when fired, and is a ceramic raw material wherein various compounds are compounded so as to give a chemical composition of 42 to 56 mass % of SiO₂, 30 to 45 mass % of Al₂O₃ and 12 to 16 mass % of MgO. A specific example of the material is one containing a plurality of inorganic raw materials selected from talc, kaolin, calcinated kaolin, alumina, aluminum hydroxide and silica, so as to give the above chemical composition.

Then, the cordierite formed is powderized to obtain a cordierite powder. At this time, the cordierite powder is allowed to have an average particle diameter of 1.0 to 5.0 µm, preferably 1.0 to 4.0 µm, more preferably 2.0 to 3.0 µm. By thus making small the average particle diameter of the cordierite powder, the ceramic green sheet obtained using such a cordierite powder can give, when fired, a dense, high-strength sintered body. When the average particle diameter of the cordierite powder is too small, there are cases that the powderization is difficult or the time for grinding is long or the handling of powder is difficult. Incidentally, the average particle diameter is a value obtained by measurement according to a laser diffraction method.

Also, the cordierite powder is allowed to have a BET specific surface area of 4.0 to 10.0 m²/g, preferably 5.0 to 8.0 m²/g, more preferably 6.0 to 7.0 m²/g. By thus controlling the BET specific surface area of the cordierite powder, the cordierite powder is unlikely to agglomerate in slurry preparation; defects, etc. are unlikely to generate in firing; and a dense fired body can be obtained. A BET specific surface area of less than 4.0 m²/g is not preferred because it is difficult to produce a dense fired body. A BET specific surface area of more than 10.0 m²/g is not preferred, either, because the cordierite powder is easy to agglomerate in slurry preparation and defects, etc. are easy to generate in firing.

As to the method for powderization, there is no particular restriction. The powderization can be conducted by, for example, ball mill, attritor, beads mill or jet mill. In such a case, however, the powderization is conducted under conditions that the average particle diameter can be made smaller than usual and the BET specific surface area can be controlled in the above range. When there is used, for example, a ball mill, the balls used are made appropriately small and an appropriate viscosity and an appropriate treatment time are selected, whereby a powder of small average particle diameter can be obtained and the BET specific surface area of the powder can be controlled in the above range. When there is used, for example, a ball mill of conventional ordinary use, it is preferred to make longer the time of grinding, and a powder of small average particle diameter such as mentioned above can be obtained with a grinding time of, for example, about 3 days. Incidentally, the powderization may be conducted for a natural cordierite ore.

In the cordierite powder obtained as above, the content of cordierite is preferably 93 mass % or more, more preferably 95 mass % or more, further preferably 100 mass %. However, it is difficult to obtain such a cordierite powder stably industrially. Therefore, from the viewpoints of availability and economy, the cordierite powder may contain a heterogeneous phase in a certain extent. The heterogeneous phase, however, is preferred to give no adverse effect on the properties of cordierite.

From the above viewpoints, the cordierite powder may contain at least one kind of crystalline phase composed of A1, Mg, Si and O similarly to cordierite, selected from the group consisting of mullite, spinel, sapphirine and corundum. The total content of cordierite, mullite, spinel, sapphirine and corundum in the cordierite powder is preferably 93 mass % or more, more preferably 95 mass % or more, particularly preferably 99 mass % or more.

The cordierite may contain Ti dissolved therein. The dissolution of Ti improves the sinterability of cordierite. Too high a content of Ti is not preferred because it impairs the inherent properties of cordierite such as low thermal expansion and the like. Therefore, the content of Ti dissolved is preferably 0.7 mass % or less, more preferably 0.5 mass % or less in terms of oxide (TiO₂) relative to the total cordierite including TiO₂.

Next, there is prepared a slurry containing 100 parts by mass of the cordierite powder and 14.0 to 19.0 parts by mass of a binder. The content of the binder is preferably 15.0 to 18.0 parts by mass, more preferably 16.0 to 17.0 parts by mass relative to 100 parts by mass of the cordierite powder. With such a binder content, generation of defects, etc. can be prevented when the slurry is formed into a ceramic green sheet or when the ceramic green sheet is fired. A binder content of less than 14.0 parts by mass relative to 100 parts by mass of the cordierite powder is not preferred because forming of slurry into sheet shape is difficult and defects, etc. generate in firing. A binder content of more than 19.0 parts by mass relative to 100 parts by mass of the cordierite powder is not preferred because drying in forming is difficult and, even if drying is possible, the sheet obtained is sticky, making very difficult the handling in subsequent operation.

The slurry may contain a plasticizer, a dispersing agent, etc. other than the ceramic and the binder, as mentioned above.

The dispersing agent is contained in an amount of preferably 0.5 to 2.5 parts by mass, more preferably 1.0 to 2.0 parts by mass relative to 100 parts by mass of the cordierite powder. An amount of less than 0.5 parts by mass induces a reduction in dispersibility of cordierite powder and may generate defects, etc. in ceramic green sheet formed. With an amount of more than 2.5 parts by mass, the dispersibility of cordierite powder is unchanged but impurities during firing increase.

The plasticizer is contained in an amount of preferably 5.0 to 9.0 parts by mass, more preferably 6.0 to 8.0 parts by mass relative to 100 parts by mass of the cordierite powder. With an amount of less than 5.0 parts by mass, the ceramic green sheet obtained is too soft and tends to deform in processing thereof. With an amount of more than 9.0 parts by mass, the ceramic green sheet obtained is too hard, resulting in inferior handleability (e.g., crack is occurred just by bending).

In order to mix individual raw materials to obtain a slurry, it is preferred to use an alumina pot for pot milling or use a trommel for stirring and mixing.

The slurry obtained by mixing of individual raw materials is preferably subjected to vacuum degassing in order to remove air bubbles. The vacuum degassing is preferably conducted by placing the slurry in a vessel made of, for example, a metal (e.g. stainless steel), a glass or a synthetic resin and making vacuum (about 1,000 to 10,000 Pa) the vessel inside using a vacuum apparatus.

In order to remove the coarse particles, undissolved binder lumps, etc. present in the slurry, it is preferred to filter the slurry through a net of 100 to 400 meshes [pore diameter (opening): 30 to 100 µm] . The material for net may be a metal (e.g. stainless steel), a synthetic resin (e.g. nylon) or the like.

The viscosity of the slurry obtained in the slurry preparation step is 2.0 to 6.0 Pa·s, preferably 3.0 to 5.0 Pa·s, particularly preferably 3.5 to 4.5 Pa·s. Such a viscosity range is preferred because the slurry is formed into a sheet shape easily. Too high or too low a slurry viscosity may make difficult the forming. Incidentally, the slurry viscosity is a value obtained by measurement using a B type viscometer.

### (Forming step)

Next, the slurry obtained by the above method is formed into a sheet shape (a forming step). The method for forming is not particularly restricted, and the forming can be conducted by a known method such as doctor blade method, press forming, rolling, calendering or the like.

With respect to the conditions for forming into a sheet shape, it is preferred, in the case of doctor blade method, to divide the drying zone into four sections and increasing the drying temperature stepwise. The speed of forming and the temperature of drying need be varied arbitrarily depending upon the kind and amount of the solvent contained in the slurry.

As to the thickness of the ceramic green sheet produced, there is no particular restriction. The thickness can be arbitrarily determined so as to satisfy the application of the sheet. For example, the thickness is preferred to be the same as in the above-mentioned level of the present ceramic green sheet.

The ceramic green sheet obtained is fired and used as a sheet-shaped ceramic (cordierite). As to the conditions for firing, there is no particular restriction, and ordinary firing conditions for cordierite may be used. The sheet-shaped ceramic obtained is dense and superior in thermal shock resistance.

### Examples

The present invention is described more specifically below by way of Examples. However, the present invention is not restricted to these Examples.

### (Example 1)

Cordierite having an average particle diameter of 10 µm was subjected to wet grinding for 2 hours using zirconia balls of 1 mm in diameter, in a SC mill which is a beads mill, to obtain a cordierite powder having an average particle diameter of 2.5 µm. The cordierite powder had a BET specific surface area of 6.5 m²/g. The cordierite powder was dried using a spray drier. The drying caused powder agglomeration. To disintegrate the agglomerated powder, the cordierite powder, a dispersing agent and a solvent (toluene and 2-propanol) were placed in an alumina pot to conduct pot milling for 20 hours. The proportions of individual components were 100 parts by mass of cordierite powder, 1.5 parts by mass of dispersing agent, 44 parts by mass of toluene and 30 parts by mass of 2-propanol relative to 100 parts by mass of the cordierite powder. The measurement of average particle diameter was conducted by a laser diffraction method using SALD-2000 (trade name) produced by Shimadzu Corporation. The measurement of BET specific surface area was conducted using FlowSorb 2300 (trade name) produced by Shimadzu Corporation.

Then, to the alumina pot were added a binder solution and a plasticizer, followed by pot milling for 20 hours. As the binder, polyvinyl butyral was used in an amount of 17 parts by mass relative to 100 parts by mass of the cordierite powder. As the plasticizer, a phthalic acid ester was used in an amount of 7.5 parts by mass relative to 100 parts by mass of the cordierite powder.

The resulting slurry was transferred into a polyethylene container and vacuum deaeration was conducted in order to conduct viscosity control and remove the air bubbles present in the slurry. The slurry viscosity after vacuum deaeration was 5.0 Pa·s. The measurement of viscosity was conducted using LVT-E (trade name) produced by BROOKFIELD Co. under the condition of 25°C (slurry temperature).

After the deaeration, the slurry was filtered using a nylon mesh of 400 meshes (opening diameter = 50 µm), in order to remove the coarse particles, undissolved binder lumps, etc. present in the slurry.

The slurry after filtration was formed into a ceramic green sheet (Example 1) of 300 µm in thickness, by a doctor blade method. The distance between blades was adjusted arbitrarily.

The ceramic green sheet obtained was kept, for firing, in a nitrogen/hydrogen reducing atmosphere at 1,357°C for 2 hours, to obtain a ceramic sheet. Incidentally, in the course of temperature elevation, water was added to promote binder decomposition. For the ceramic sheet obtained, a thermal shock resistance test was conducted and its denseness was examined according to the following methods. The results are shown in Table 1.

### (Thermal shock resistance test)

Four green sheets obtained above were laminated and fired to obtain a cordierite substrate of 1 mm in thickness. The cordierite substrate was cut into a size of 85 mm (length) and 50 mm (width). 50 such cut pieces were piled at intervals of 0.5 mm to form a stack. The stack was fixed in a metal-made can, and the can was placed downstream of a gas burner. A thermal shock test was conducted by allowing an air heated at 600°C by the gas burner and an air of room temperature to flow at a flow rate of 3 Nm³/min alternately for 10 minutes each and repeating this operation 10 times. After the test, the cordierite substrates were taken out and the number of broken substrates of 50 substrates was examined. As an index indicating thermal shock resistance, there was used breakage ratio [(number of substrates broken by thermal shock test/50) x 100]. In this test, there was no broken substrate; therefore, the breakage ratio was 0%.

### (Denseness)

As an index indicating denseness, there was used the density of cordierite substrate after firing. The measurement of the density was conducted using the Archimedes method. Since the theoretical density of dense cordierite is 2.50 g/cm³, a density closer to 2.50 indicates higher denseness. The measurement of the density of the cordierite substrate produced above gave 2.42 g/cm³.

**Table 1**

| | Thermal shock resistance (unit: %) | Denseness (unit: g/cm³) |
|---|---|---|
| Example 1 | 0 | 2.42 |
| Example 2 | 0 | 2.422 |
| Example 3 | 0 | 2.418 |
| Example 4 | 0 | 2.419 |
| Example 5 | 0 | 2.419 |
| Example 6 | 0 | 2.423 |
| Example 7 | 0 | 2.415 |
| Comparative Example 1 | 0 | 2.321 |
| Comparative Example 2 | Forming was impossible. | |
| Comparative Example 3 | 0 | 2.351 |
| Comparative Example 4 | 0 | 2.335 |
| Comparative Example 5 | 94 | 3.7 |

### (Examples 2 to 7 and Comparative Examples 1 to 4)

Example 6 is not within the scope of claim 1.

The average particle diameter and BET specific surface area of cordierite powder, the amount of binder, the amount of plasticizer, the amount of dispersing agent and the viscosity of slurry were controlled as shown in Table 2, to form ceramic green sheets. Other forming parameters were the same as in Example.

**Table 2**

| | Average particle diameter (unit: µm) | BET specific surface area (unit: m²/g) | Amount of binder (parts) | Amount of plasticizer (Parts) | Amount of dispersing agent (Parts) | Slurry viscosity (Pa·s) |
|---|---|---|---|---|---|---|
| Example 1 | 2.5 | 6.5 | 17 | 7.5 | 1.5 | 5.0 |
| Example 2 | 1.9 | 8.1 | 18 | 8.0 | 2.0 | 5.0 |
| Example 3 | 2.9 | 5.3 | 15 | 6.5 | 1.0 | 5.0 |
| Example 4 | 2.5 | 6.5 | 16 | 7.0 | 1.5 | 5.0 |
| Example 5 | 2.5 | 6.5 | 18 | 8.0 | 1.5 | 5.0 |
| Example 6 | 1.0 | 11.7 | 19 | 8.5 | 2.0 | 5.0 |
| Example 7 | 5.0 | 4.2 | 14 | 6.0 | 1.0 | 5.0 |
| Comparative Example 1 | 6.0 | 3.5 | 14 | 6.0 | 1.0 | 5.0 |
| Comparative Example 2 | 2.5 | 6.5 | 12 | 7.5 | 1.5 | 5.0 |
| Comparative Example 3 | 2.5 | 6.5 | 20 | 7.5 | 1.5 | 5.0 |
| Comparative Example 4 | 2.5 | 6.5 | 17 | 7.5 | 1.5 | 10.0 |
| Comparative Example 5 | 1.2 | 6.7 | 7.5 | 3.8 | 1.5 | 5.0 |

### (Comparative Example 5)

A ceramic green sheet was formed in the same manner as in Example 1 except that the cordierite powder was replaced by an alumina powder having an average particle diameter of 1.2 µm and a BET specific surface area of 6.7 m²/g. In the same manner as in Example 1, a ceramic sheet was produced therefrom, and its thermal shock resistance test was conducted and its denseness was examined. The results are shown in Table 1. Incidentally, the alumina was dense and its density is shown in Table 1 as reference.

The following is appreciated from Table 1. The fired bodies of the ceramic green sheets of Examples 1 to 7 are superior in thermal shock resistance and density. The fired body of the ceramic green sheet of Comparative Example 1 was not dense owing to the large particle diameter. The ceramic green sheet of Comparative Example 2 had a plurality of cracks owing to the too small amount of the binder used, making it impossible the production of sample (ceramic sheet). The fired body of the ceramic green sheet of Comparative Example 3 was not dense owing to the too large amount of the binder used. The fired body of the ceramic green sheet of Comparative Example 4 contained air holes inside and was low in density because the viscosity in tape forming was too high and a large number of air bubbles were taken into the tape. The ceramic green sheet of Comparative Example 5 used no cordierite powder; therefore, its fired body was inferior in thermal shock resistance.

### Industrial Applicability

The ceramic green sheet produced by the present invention can be used in production of various tape-shaped, ceramic formed bodies such as a wiring board and the like, particularly in production of tape-shaped, ceramic formed bodies used in environments which receive sharp thermal shock, such as electrode for purification of exhaust gas emitted from factory, electrode for purification of exhaust gas emitted from vehicle (e.g. automobile) and terminal for sensing of exhaust gas component.

## Claims

1. A process for producing a ceramic green sheet, which includes the steps of:
(i) preparing a slurry containing 100 parts by mass of a cordierite powder having an average particle diameter of 1.0 to 5.0 pm and a BET specific surface area of 4.0 to 10.0 m²/g and 14.0 to 19.0 parts by mass of a binder, and
(ii) forming the slurry into a sheet shape, wherein the slurry prepared in step (i) has a viscosity of 2.0 to 6.0 Pa·s.

2. A process according to claim 1, wherein the slurry further contains 0.5 to 2.5 parts by mass of a dispersing agent and 5.0 to 9.0 parts by mass of a plasticizer relative to 100 parts by mass of the cordierite powder.

## Patentansprüche

1. Verfahren zur Herstellung eines plattenförmigen Keramikgrünlings, das folgende Schritte umfasst:
(i) das Herstellen einer Aufschlämmung mit 100 Masseteilen eines Cordieritpulvers mit einem mittleren Teilchendurchmesser von 1,0 bis 5,0 µm und einer spezifischen BET-Oberfläche von 4,0 bis 10,0 m²/g und 14,0 bis 19,0 Masseteilen eines Bindemittels und
(ii) das Bringen der Aufschlämmung in eine Plattenform,
wobei die in Schritt (i) hergestellte Aufschlämmung eine Viskosität von 2,0 bis 6,0 Pa·s aufweist.

2. Verfahren nach Anspruch 1, wobei die Aufschlämmung, bezogen auf 100 Masseteile des Cordieritpulvers, weiters 0,5 bis 2,5 Masseteile eines Dispersionsmittels und 5,0 bis 9,0 Masseteile eines Plastifizierungsmittels enthält.

## Revendications

1. Procédé pour produire une feuille en céramique verte, comprenant les étapes consistant à :
(i) préparer une barbotine contenant 100 parts en poids d'une poudre de cordiérite ayant un diamètre particulaire moyen de 1,0 à 5,0 µm et une surface spécifique BET de 4,0 à 10,0 m²/g et 14,0 à 19,0 parts en poids d'un liant, et
(ii) former la barbotine en une forme de feuille, dans lequel la barbotine préparée à l'étape (i) a une viscosité de 2,0 à 6,0 Pa·s.

2. Procédé selon la revendication 1, dans lequel la barbotine contient en outre de 0,5 à 2,5 parts en poids d'un agent dispersant et de 5,0 à 9,0 parts en poids d'un plastifiant par rapport à 100 parts en poids de poudre de cordiérite.
